(19) Europäisches Patentamt / European Patent Office / Office européen des brevets

(11) **EP 4 712 351 A1**

(12) **EUROPEAN PATENT APPLICATION**

(43) Date of publication:
18.03.2026 Bulletin 2026/12

(21) Application number: 25201395.8

(22) Date of filing: 10.09.2025

(51) International Patent Classification (IPC):
*H03M 9/00* (2006.01)

(52) Cooperative Patent Classification (CPC):
H03M 9/00

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH LA MA MD TN

(30) Priority: 13.09.2024 US 202418885561

(71) Applicant: Avago Technologies International Sales
Pte. Limited
Singapore 768923 (SG)

(72) Inventors:
• Vasani, Anand Jitendra
Irvine, 92620 (US)
• Yoon, Taehun
Irvine, 92618 (US)

(74) Representative: Dilg, Haeusler, Schindelmann
Patentanwaltsgesellschaft mbH
Leonrodstraße 58
80636 München (DE)

Remarks:
A request for correction the drawings has been filed pursuant to Rule 139 EPC. A decision on the request will be taken during the proceedings before the Examining Division (Guidelines for Examination in the EPO, A-V, 3.).

(54) **BANDWIDTH AND POWER EFFICIENT FULLY CMOS MUX**

(57) A module including a first slice and a second slice. The first slice and the second slice receive data from a plurality of inputs. A first stage of the first slice selects a first subset of the inputs in synchronization with an edge of a first clock. In synchronization with a second clock, a second stage of the first slice selects an input from the first subset. A first stage of the second slice selects a second subset of the inputs in synchronization with an edge of the second clock. In synchronization with the first clock, a second stage of the second slice selects an input from the second subset.

FIG. 2A – Module 100(A)

## Description

### BACKGROUND

In the increasingly competitive next generation high-speed wireline market over 200 gigabits/second, low-power operation and high area efficiency still with good performance are the key requirements especially for artificial intelligence and machine learning environments and any other high-speed networking infrastructure.

### BRIEF DESCRIPTION OF DRAWINGS

The accompanying drawings, which are incorporated in and form a part of this specification, illustrate examples of the disclosure and, together with the description, explain principles of the examples.

FIG. 1 a functional block diagram of an exemplary module, in accordance with one or more embodiments of the disclosure.

FIGS. 2A-2C illustrate examples of an exemplary module, in accordance with one or more embodiments of the disclosure.

FIGS. 3A-3C illustrate examples of an exemplary Q-mux slice, in accordance with one or more embodiments of the disclosure.

FIGS. 4A-4C illustrate examples of an exemplary I-mux slice, in accordance with one or more embodiments of the disclosure.

FIGS. 5A and 5B illustrate an exemplary interpolation technique, in accordance with one or more embodiments of the disclosure.

FIG. 5C illustrates an exemplary timing diagram, in accordance with one or more embodiments of the disclosure.

FIG. 6 illustrates an exemplary multiplexer system, in accordance with one or more embodiments of the disclosure.

In the drawings, like reference symbols and numerals indicate the same or similar components. Like elements in the various figures are denoted by like reference symbols and numerals for consistency. Unless otherwise indicated, like elements and method steps are referred to with like reference numerals.

### DETAILED DESCRIPTION OF THE INVENTION

The following describes technical solutions in this specification with reference to the accompanying drawings. Exemplary embodiments are described in detail with reference to the accompanying drawings.

The terminology used herein is for describing various examples only, and is not to be used to limit the disclosure. Unless otherwise defined, all terms, including technical and scientific terms, used herein have the same meaning as commonly understood by one of ordinary skill in the art to which this disclosure pertains and after an understanding of the disclosure of this application.

Terms, such as those defined in commonly used dictionaries, are to be interpreted as having a meaning that is consistent with their meaning in the context of the relevant art and the disclosure of this application. Although the present technology has been described by referring to certain examples, workers skilled in the art will recognize that changes may be made in form and detail without departing from the scope of the discussion.

To support data rate over 200 gigabits/second, which is 100 gigabits/second with tight timing requirement, almost 60~70% of power is consumed by the serializer and its clocking. Improper architecture selection in high-speed serializer design can lead to poor power efficiency as well as performance. At the data rate over 200 gigabits/second, difficulties of generating and distributing half-rate clocks and its stringent timing requirement force quarter-rate architecture for the final MUX implementation. However, large self-loading due to the shared output node by four branches of a typical single stage multiplexer can makes it difficult to obtain a full-rate symbol with low power consumption. Accordingly, there is a need in the art for an improved serializer.

Throughout the description, ordinal numbers (e.g., first, second, third, etc.) may be used as an adjective for an element (i.e., any noun in the description). Although terms such as "first," "second," and "third" may be used herein to describe various members, components, regions, layers, or sections, these members, components, regions, layers, or sections are not to be limited by these terms. Rather, these terms are only used to distinguish one member, component, region, layer, or section from another member, component, region, layer, or section.

The use of ordinal numbers is not to imply or create any particular ordering of the elements nor to limit any element to being only a single element unless expressly disclosed, such as by the use of the terms "before," "after," "single," and other such terminology. Rather, the use of ordinal numbers is to distinguish between the elements. By way of an example, a first element is distinct from a second element, and the first element may encompass more than one element and succeed (or precede) the second element in an ordering of elements.

Thus, a first member, component, region, layer, or section referred to in examples described herein may also be referred to as a second member, component, region, layer, or section without departing from the teachings of the examples.

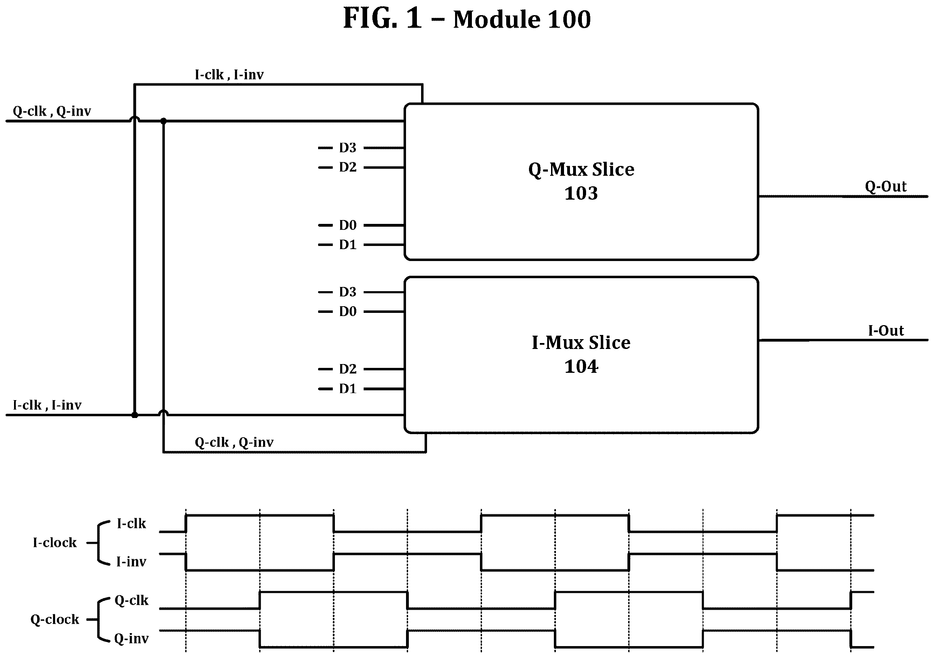

Referring to FIG. 1, a functional block diagram of module 100 according to exemplary embodiments is shown. Module 100 may include Q-mux slice 103 and I-mux slice 104. Q-mux slice 103 and I-mux slice 104 may each receive Q-clock and I-clock. I-clock is a differential clock having I-clk and I-inv as a complementary pair of clocks. By way of example, a rising edge of I-clk may be aligned with a falling edge of I-inv. A falling edge of I-clk may be aligned with a rising edge of I-inv. Q-clock is a differential clock having Q-clk and Q-inv as a complementary pair of clocks. By way of example, a rising edge of Q-clk may be aligned with a falling edge of Q-inv. A falling edge of Q-clk may be aligned with a rising edge of Q-inv.

I-clock is an in-phase clock. An in-phase clock is a clock having a 0-degree phase shift. Q-clock is a quadrature-phase clock. A quadrature-phase clock is a clock having a 90 degree phase-shift from I-clock. Q-clock is in synchronization with I-clock while being out of phase with I-clock.

Q-mux slice 103 and I-mux slice 104 may each receive data from input lines D0-D3, as illustrated in the example of FIG. 1. Those skilled in the art will appreciate Q-mux slice 103 and I-mux slice 104 may each receive data from sources other than input lines D0-D3.

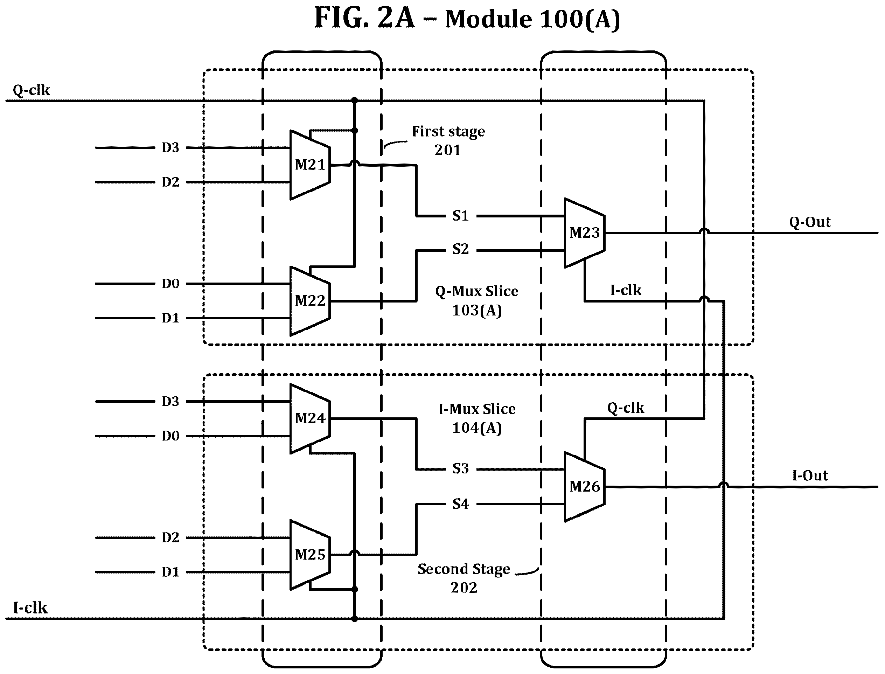

FIGS. 2A-2C illustrate examples of module 100. Referring to FIG. 2A, module 100(A) is illustrated. Module 100(A) is a basic version of module 100. The basic version of module 100 is the most fundamental configuration of module 100. Module 100(A) may include Q-mux slice 103(A) and I-mux slice 104(A). The example of FIG. 2A may also include first stage 201 and second stage 202.

First stage 201 may include multiplexers M21 and M22 of Q-mux slice 103(A). Multiplexer M21 is electrically connected directly to a first grouping D3, D2 of the input lines D0-D3 in the example of FIG. 2A.

In synchronization with an edge of Q-clk, multiplexer M21 may select either input line D3 or input line D2 from the first grouping D3, D2 of the input lines D0-D3. Multiplexer M21 may electrically connect input line D3 directly to data line S1 in response to multiplexer M21 selecting input line D3. Alternatively, multiplexer M21 may electrically connect input line D2 directly to data line S1 in response to multiplexer M21 selecting input line D2.

Also in synchronization with the edge of Q-clk, multiplexer M22 may select either input line D0 or input line D1 from the second grouping D0, D1 of the input lines D0-D3. The combination of input lines D0-D3 in the second grouping D0, D1 differs from the combination of input lines D0-D3 in the first grouping D3, D2. Multiplexer M22 may electrically connect input line D0 directly to data line S2 in response to multiplexer M22 selecting input line D0. Alternatively, multiplexer M22 may electrically connect input line D1 directly to data line S2 in response to multiplexer M22 selecting input line D1. Although the example of FIG. 2A illustrates the first grouping D3, D2 and the second grouping D0, D1, those skilled in the art will appreciate there may be alternative groupings of the input lines D0-D3 for the first and second groupings.

Second stage 202 may include multiplexer M23 of Q-mux slice 103(A). Multiplexer M23 is electrically connected directly to multiplexers M21 and M22 in the example of FIG. 2A. By way of illustration in FIG. 2A, data line S1 electrically connects the output of multiplexer M21 directly to an input of multiplexer M23. Data line S2 electrically connects the output of multiplexer M22 directly to another input of multiplexer M23. In synchronization with an edge of I-clk, multiplexer M23 may select either data line S1 or data line S2. Multiplexer M23 may electrically connect data line S1 directly to an output line (Q-out) in response to multiplexer M23 selecting data line S1. Alternatively, multiplexer M23 may electrically connect data line S2 directly to the output line (Q-out) in response to multiplexer M23 selecting data line S2.

First stage 201 may also include multiplexers M24 and M25 of I-mux slice 104(A). In synchronization with an edge of I-clk, multiplexer M24 may select either input line D3 or input line D0 from the third grouping D3, D0 of the input lines D0-D3. The combination of input lines D0-D3 in the third grouping D3, D0 differs from the combination of input lines D0-D3 in the first grouping D3, D2. The combination of input lines D0-D3 in the third grouping D3, D0 differs from the combination of input lines D0-D3 in the second grouping D0, D1, as well. Multiplexer M24 may electrically connect input line D3 directly to data line S3 in response to multiplexer M24 selecting input line D3. Alternatively, multiplexer M24 may electrically connect input line D0 directly to data line S3 in response to multiplexer M24 selecting input line D0.

Also in synchronization with the edge of I-clk, multiplexer M25 may select either input line D2 or input line D1 from the fourth grouping D2, D1 of the input lines D0-D3. The combination of input lines D0-D3 in the fourth grouping D2, D1 differs from the combination of input lines D0-D3 in the first grouping D3, D2. The combination of input lines D0-D3 in the fourth grouping D2, D1 differs from the combination of input lines D0-D3 in the second grouping D0, D1, as well. Likewise, the combination of input lines D0-D3 in the fourth grouping D2, D1 differs from the combination of input lines D0-D3 in the third grouping D3, D0. Multiplexer M25 may electrically connect input line D2 directly to data line S4 in response to multiplexer M25 selecting input line D2. Alternatively, multiplexer M25 may electrically connect input line D1 directly to data line S4 in response to multiplexer M25 selecting input line D1.

Although the example of FIG. 2A illustrates the third grouping D3, D0 and the fourth grouping D2, D1, those skilled in the art will appreciate there may be alternative groupings of the input lines D0-D3 for the third and fourth groupings.

Second stage 202 also may include multiplexer M26 of I-mux slice 104(A). Multiplexer M26 is electrically connected directly to multiplexers M24 and M25 in the example of FIG. 2A. By way of illustration in FIG. 2A, data line S3 electrically connects the output of multiplexer M24 directly to an input of multiplexer M26. Data line S4 electrically connects the output of multiplexer M25 directly to another input of multiplexer M26. In synchronization with an edge of Q-clk, multiplexer M26 may select either data line S3 or data line S4. Multiplexer M26 may electrically connect data line S3 directly to an output line (I-out) in response to multiplexer M26 selecting data line S3. Alternatively, multiplexer M26 may electrically connect data line S4 directly to the output line (I-out) in response to multiplexer M26 selecting data line S4.

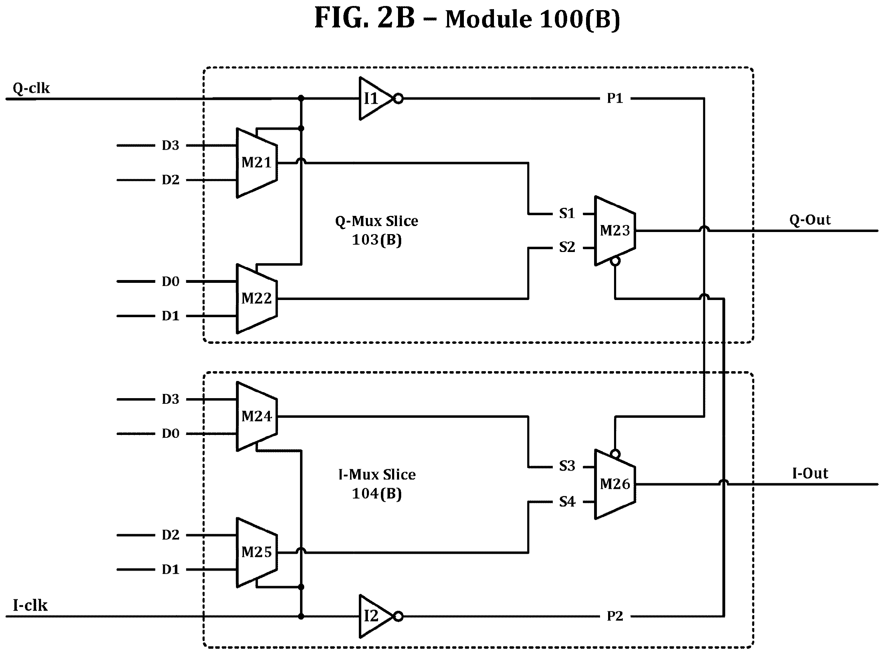

Referring to FIG. 2B, module 100(B) is illustrated. Module 100(B) may include the configuration of module 100(A). As an illustration, Q-mux slice 103(B) may include multiplexers M21, M22 and M23. I-mux slice 103(B) may also include multiplexers M24, M25 and M26. In addition to the configuration of module 100(A), module 100(B) may include inverters I1 and I2 as illustrated in FIG. 2B. The input of inverter I1 may receive Q-clk. Clock line P1 in module 100(B) may electrically connect the output of inverter I1 directly to multiplexer M26. The input of inverter I2 may receive I-clk. Clock line P2 in module 100(B) may electrically connect the output of inverter I2 directly to multiplexer M23.

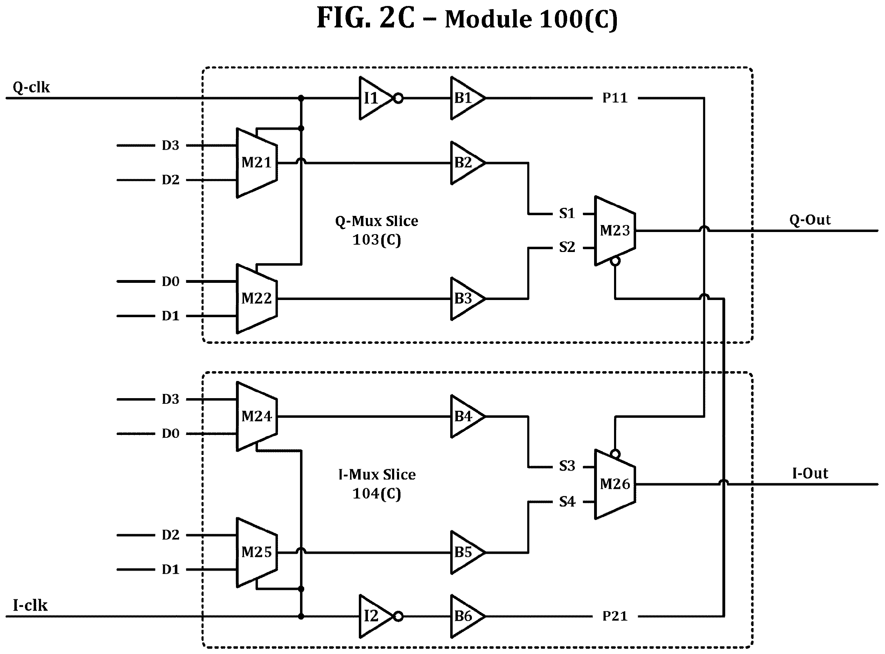

Referring to FIG. 2C, module 100(C) is illustrated. Module 100(C) may include the configuration of module 100(B). As an illustration, Q-mux slice 103(C) may include multiplexers M21, M22 and M23 along with inverter I1. I-mux slice 103(C) may also include multiplexers M24, M25 and M26 along with inverter I2. In addition to the configuration of module 100(B), module 100(C) may include buffers B1-B6 as illustrated in FIG. 2C. The input of inverter I1 may receive Q-clock. The output of inverter I1 is electrically connected directly to the input of buffer B1. Clock line P11 in module 100(C) may electrically connect the output of buffer B1 directly to multiplexer M26. The output of multiplexer M21 is electrically connected directly to the input of buffer B2. The output of multiplexer M22 is electrically connected directly to the input of buffer B3. Multiplexer M23 is electrically connected directly to buffers B2 and B3 in the example of FIG. 2C. By way of illustration in FIG. 2C, data line S1 electrically connects the output of buffer B2 directly to an input of multiplexer M23. Data line S2 electrically connects the output of buffer B3 directly to another input of multiplexer M23.

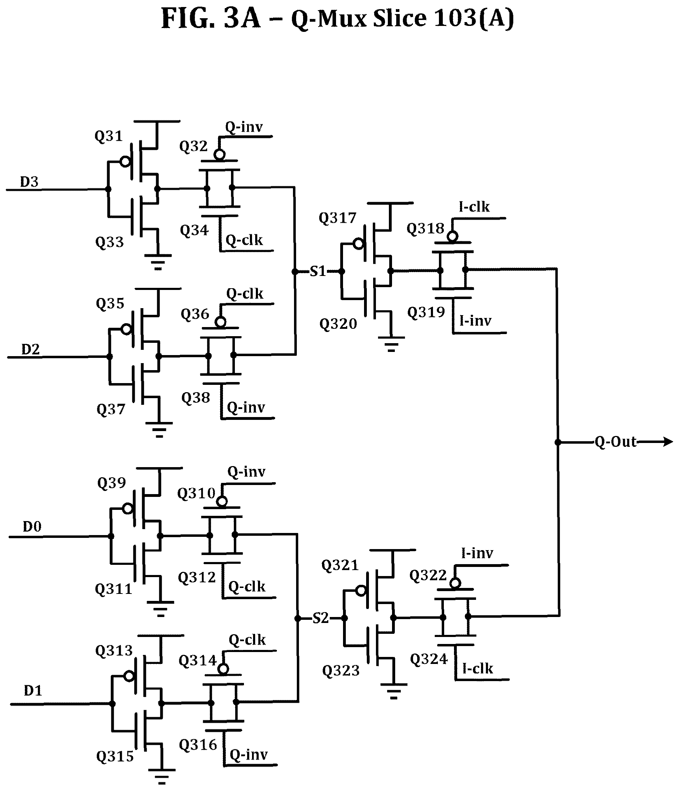

FIGS. 3A-3C illustrate examples of Q-mux slice 103. Referring to FIG. 3A, Q-mux slice 103(A) is illustrated. Q-mux slice 103(A) is a basic version of Q-mux slice 103. The basic version of Q-mux slice 103 is the most fundamental configuration of Q-mux slice 103. Q-mux slice 103(A) may include transistors Q31-Q324. Multiplexer M21 as described in the example of FIGS. 2A-2C may include transistors Q31-Q38. Multiplexer M22 as illustrated in the example of FIGS. 2A-2C may include transistors Q39-Q316. Multiplexer M23 as illustrated in the example of FIGS. 2A-2C may include transistors Q317-Q324.

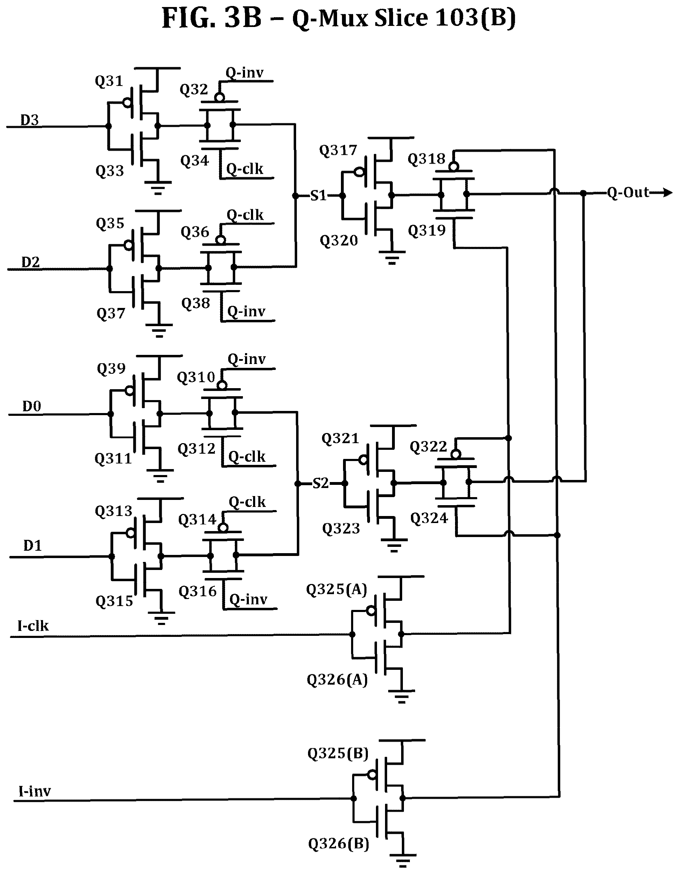

Referring to FIG. 3B, Q-mux slice 103(B) is illustrated. Q-mux slice 103(B) may include the configuration of Q-mux slice 103(A). As an illustration, Q-mux slice 103(B) may include transistors Q31-Q324. In addition to the configuration of Q-mux slice 103(A), Q-mux slice 103(B) may include transistors Q325 and Q326. In this example, inverter I2 as illustrated in FIGS. 2B and 2C may include transistors Q325(A), Q326(A), Q325(B) and Q326(B).

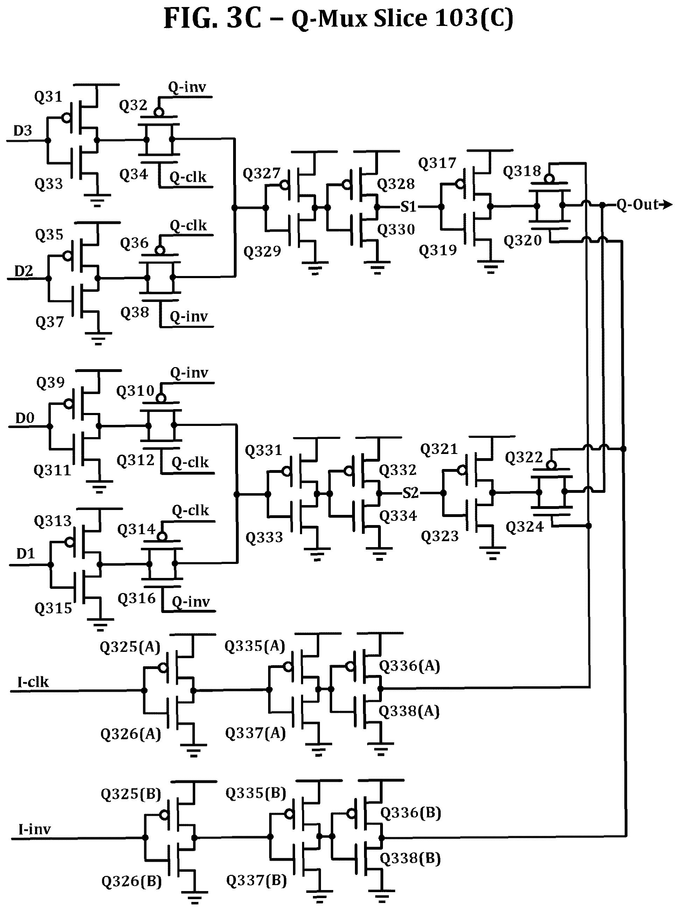

Referring to FIG. 3C, Q-mux slice 103(C) is illustrated. Q-mux slice 103(C) may include the configuration of Q-mux slice 103(B). As an illustration, Q-mux slice 103(C) may include transistors Q31-Q324. Q-mux slice 103(C) may also include transistors Q325(A), Q326(A), Q325(B) and Q326(B). In addition to the configuration of Q-mux slice 103(B), Q-mux slice 103(C) may include transistors Q327-Q334, transistors Q335(A)-Q338(A) and transistors Q335(B)-Q338(B). In this example, buffer B2 as illustrated in the example of FIG. 2C may include transistors Q327-Q330. Buffer B3 as illustrated in the example of FIG. 2C may include transistors Q331-Q334. Buffer B6 as illustrated in the example of FIG. 2C may include transistors Q335(A)-Q338(A) and transistors Q335(B)-Q338(B).

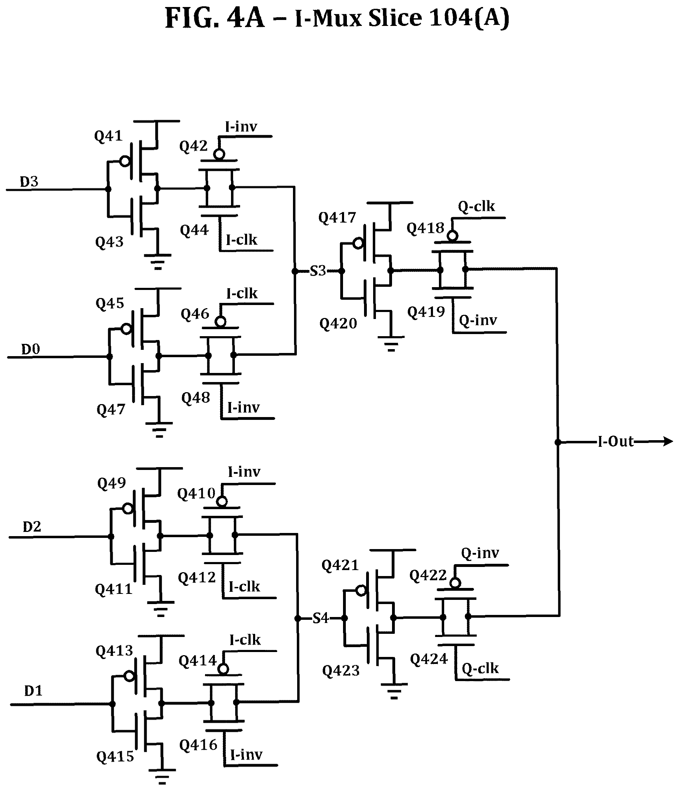

FIGS. 4A-4C illustrate examples of I-mux slice 104. Referring to FIG. 4A, I-mux slice 104(A) is illustrated. I-mux slice 104(A) is a basic version of I-mux slice 104. The basic version of I-mux slice 104 is the most fundamental configuration of I-mux slice 104. I-mux slice 104(A) may include transistors Q41-Q424. Multiplexer M24 as illustrated in the example of FIGS. 2A-2C may include transistors Q41-Q48. Multiplexer M25 as illustrated in the example of FIGS. 2A-2C may include transistors Q49-Q416. Multiplexer M26 as illustrated in the example of FIGS. 2A-2C may include transistors Q417-Q424.

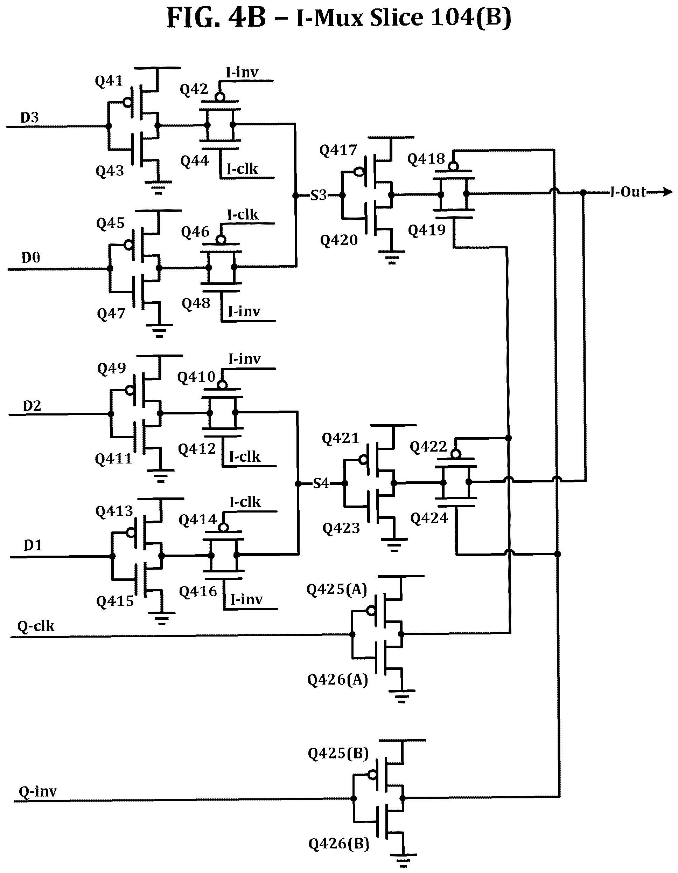

Referring to FIG. 4B, I-mux slice 104(B) is illustrated. I-mux slice 104(B) may include the configuration of I-mux slice 104(A). As an illustration, I-mux slice 104(B) may include transistors Q41-Q424. In addition to the configuration of I-mux slice 104(A), I-mux slice 104(B) may include transistors Q425(A), Q426(A), Q425(B) and Q426(B). In this example, inverter I1 as illustrated in FIGS. 2B and 2C may include transistors Q425(A), Q426(A), Q425(B) and Q426(B).

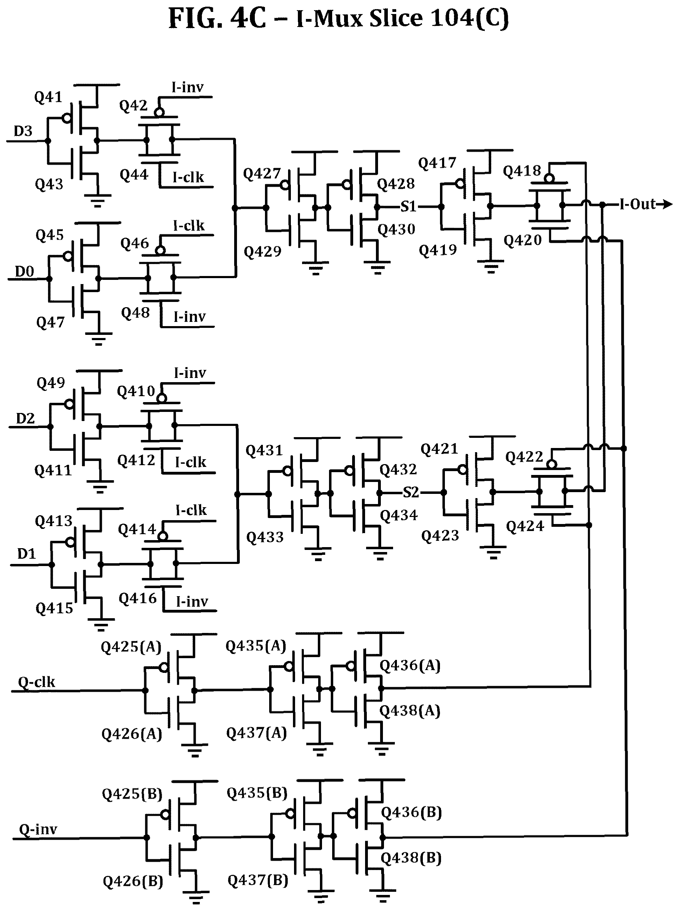

Referring to FIG. 4C, I-mux slice 104(C) is illustrated. I-mux slice 104(C) may include the configuration of I-mux slice 104(B). As an illustration, I-mux slice 104(C) may include transistors Q41-Q424. I-mux slice 104(C) may also include transistors Q425(A), Q426(A), Q425(B) and Q426(B). In addition to the configuration of I-mux slice 104(B), I-mux slice 104(C) may include transistors Q427-Q434, transistors Q435(A)-Q438(A) and transistors Q435(B)-Q438(B). In this example, buffer B4 as illustrated in the example of FIG. 2C may include transistors Q427-Q430. Buffer B5 as illustrated in the example of FIG. 2C may include transistors Q431-Q434. Buffer B6 as illustrated in the example of FIG. 2C may include transistors Q435(A)-Q438(A) and transistors Q435(B)-Q438(B).

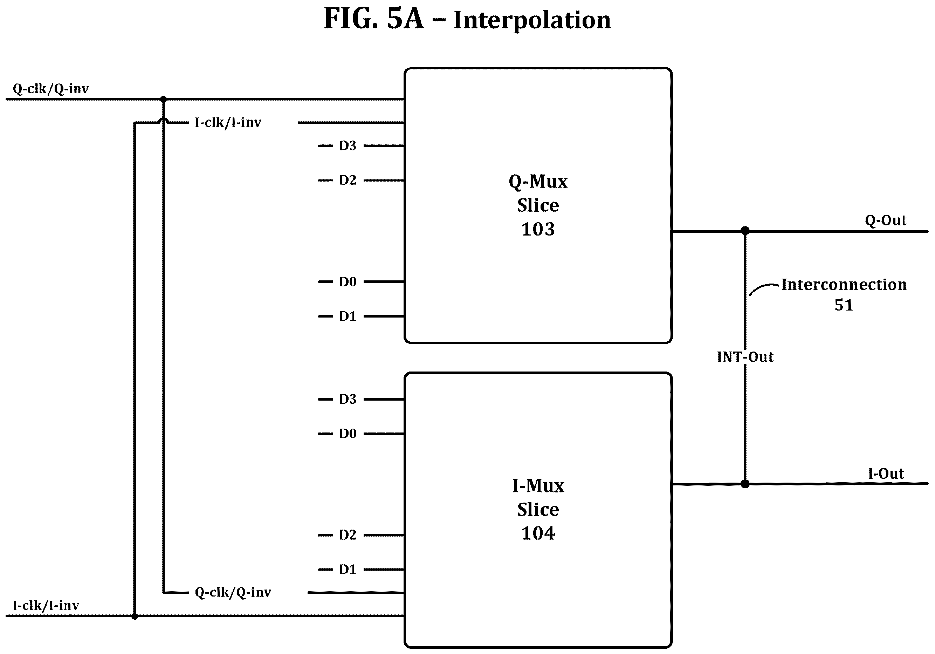

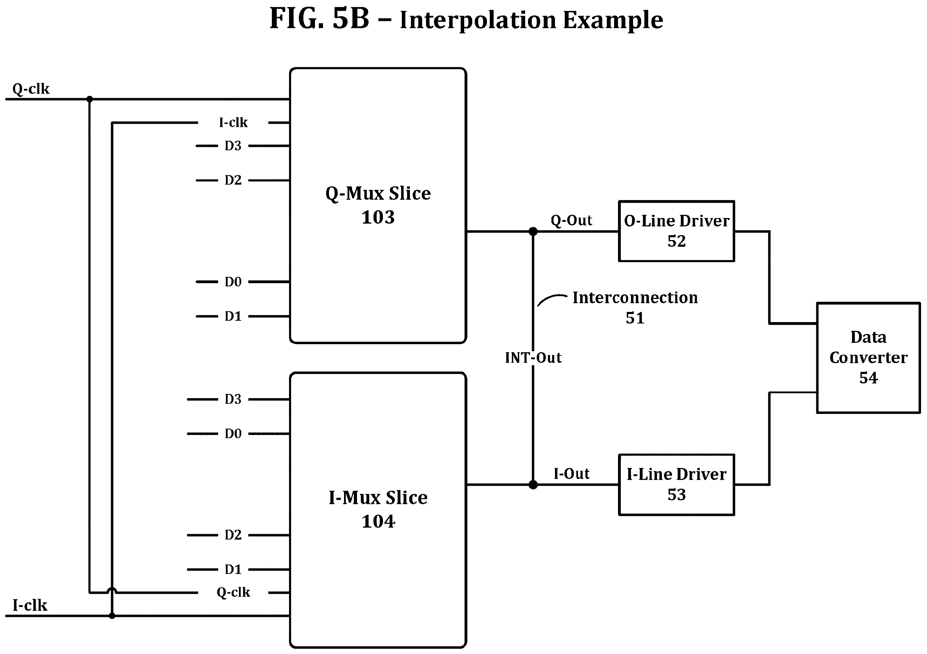

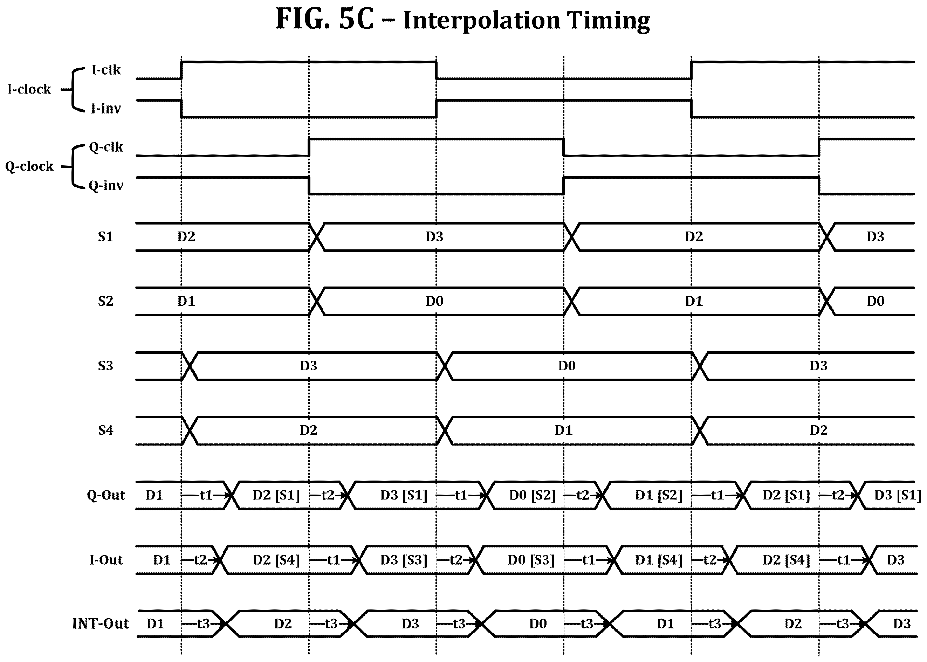

Referring to FIGS. 5A and 5B, an example interpolation technique is illustrated. FIGS. 2A-2C, 3A-3C and 4A-4C illustrate examples of module 100 in FIGS. 5A and 5B. Module 100 in FIG. 5C may include Q-mux slice 103 and I-mux slice 104.

The interpolation technique may include interconnection 51. As an illustration, in FIG. 5A, interconnection 51 may electrically connect output line (Q-out) directly to output line (I-out). Interconnection 51 may be a metal, a metal alloy, a metallic material, a doped polysilicon or other doped semiconductor material, a silicide, and/or any other electrically conductive material. As result of electrically connecting output line (Q-out) directly to output line (I-out), the example of FIG. 5B illustrates that interconnection 51 may short circuit an output of multiplexer M23 in Q-mux slice 103 directly to an output of multiplexer M26 in I-mux slice 104.

Illustrated in the interpolation example of FIG. 5B are Q-line driver 52, I-line driver 53 and digital-to-analog converter 54. Q-line driver 52 may be implemented as a pre-driver, a pre-amplifier, a pre-stage driver, a signal conditioner, and intermediate driver and/or any other electronic circuitry that may condition or amplify a signal on output line (Q-out). Similarly, I-line driver 53 may be implemented as a pre-driver, a pre-amplifier, a pre-stage driver, a signal conditioner, and intermediate driver and/or any other electronic circuitry that may condition or amplify a signal on output line (I-out). Digital-to-analog converter 54 may be implemented as electronic circuitry that may convert, from digital form to analog form, digital information from Q-line driver 52 and I-line driver 53.

Turning now to FIG. 5C, a timing diagram for the interpolation technique is illustrated. As a background for the interpolation technique, a clock load may be generally considered by those skilled in art as the total impedance that a clock driver must manage when generating and delivering clock signals for circuitry in an electronic device. An edge quality mismatch may refer to any inconsistency in the rising and/or falling edges for any of the clocks. Even if the timing error can be minimized by a calibration scheme that causes a clock driver to dynamically adjust the edges of a clock, edge quality mismatches in one or more of the clocks can result from differences between even and odd output signal paths. Consequences of the timing errors and the edge quality mismatch can emerge in the form of signal quality errors and/or timing errors in a final output.

Time delays t1 and t2 are illustrated in FIG. 5C. Time delay t2 is a time duration shorter than time delay t1. Time delays t1 and t2 may occur in the absence of interconnection 51.

For Q-mux slice 103, time delay t1 is a time duration for a signal from first stage 201 to propagate onto output line (Q-out) through multiplexer M23. As illustrated in FIG. 5C, time delay t1 may commence in Q-mux slice 103 at a rising edge of Q-clk or a falling edge of Q-clk. Also for Q-mux slice 103, the time delay t2 is the time duration for a signal to propagate from any of the data lines S1-S2 onto output line (Q-out). As illustrated in FIG. 5C, time delay t2 may commence in Q-mux slice 103 at a rising edge of I-clk or a falling edge of I-clk.

For I-mux slice 104, time delay t1 is a time duration for a signal from first stage 201 to propagate onto output line (I-out) through multiplexer M26. As illustrated in FIG. 5C, time delay t1 may commence in I-mux slice 104 at a rising edge of I-clk or a falling edge of I-clk. Also for I-mux slice 104, the time delay t2 is the time duration for a signal to propagate from any of the data lines S1-S2 onto output line (I-out). As illustrated in FIG. 5C, time delay t2 may commence in I-mux slice 104 at a rising edge of Q-clk or a falling edge of Q-clk.

As an improvement, interconnection 51 may short circuit an output of multiplexer M23 in Q-mux slice 103 directly to an output of multiplexer M26 in I-mux slice 104. An interpolated output INT-out may occur due to the presence of interconnection 51. This approach may allow for any transition of data on output line (I-out) exist concurrently with any transition of data on output line (Q-out), as illustrated by the transitions in interpolated output INT-out. As illustrated in FIG. 5C, interconnection 51 may interpolate data on output line (I-out) with data on output line (Q-out). The same data in the form of interpolated data may coexist on output line (I-out) and output line (Q-out) as a result of interconnection 51. Time delay t3 in FIG. 5C is the time duration for a transition of the interpolated data. In the absence of interconnection 51, a time delay for data on output line (I-out) and a time delay for data on output line (Q-out) would respectively alternate between time delay t1 and time delay t2, which may result in even-odd timing error at the output. Accordingly, the presence of interconnection 51 is the improvement over the previous invention.

Time delay t3, is shorter than time delay t1 while being longer than time delay t2, may be an average time of:

$$\text{Time delay t3} = (\text{time delay t1} + \text{time delay t2}) / 2$$

As an improvement over a conventional multiplexer, module 100 may include the addition of inverters I1 and I2 as in FIGS. 2B-2C, 3B-3C and 4B-4C.

Inverter I1 may be disposed in a routing path for Q-clock, so that second slice 202 of I-mux slice 104 may receive an inverted Q-clock. Time delay t2 in I-mux slice 104 may represent a time duration due to a delay caused by the inverter I1 and a delay caused by multiplexer M26. Time delay t2 in I-mux slice 104 may commence a clock edge of I-clock. In the absence of inverter I1, a time difference between time delay t1 and time delay t2 in I-mux slice 104 would be large since time delay t1 in I-mux slice 104 may consist of propagation delays due multiplexers M24 and M26 in some instances and, alternatively, propagation delays due to multiplexers M25 and M26 in other instances. The inverter I1 may compensate the delay difference between paths.

Inverter I2 may be disposed in a routing path for I-clock, so that second slice 202 of Q-mux slice 103 may receive an inverted I-clock. Time delay t2 in Q-mux slice 103 may represent a time duration due to a delay caused by the inverter I2 and a delay caused by multiplexer M23. Time delay t2 in Q-mux slice 103 may commence a clock edge of I-clock. In the absence of inverter I2, a time difference between time delay t1 and time delay t2 in Q-mux slice 103 would be large since time delay t1 in Q-mux slice 103 may consist of propagation delays due multiplexers M21 and M23 in some instances and, alternatively, propagation delays due to multiplexers M22 and M23 in other instances. The inverter I2 may compensate the delay difference between paths.

Disposing inverter I1 in the routing path for Q-clock may cause a propagation delay of Q-clock to second stage 202 of I-mux slice 104 by an amount of time delay t2 for Q-clock to propagate through inverter I1. Specifically, inverter I1 may reduce the delay different between t1 and t2 in FIG. 5C. Inverter I2 may be disposed in a routing path for I-clock, so that second stage 202 of Q-mux slice 103 may receive an inverted I-clock. Disposing inverter I2 in the routing path for I-clock may cause a propagation delay of I-clock to second stage 202 of Q-mux slice 103 by an amount of time delay t2 for I-clock to propagate through inverter I2. Specifically, inverter I2 may reduce the delay different between t1 and t2 in FIG. 5C. Disposing inverter I1 in the routing path for Q-clock along with disposing inverter I2 in the routing path for I-clock may balance any even and odd clock edge delays that may emerge in the interpolation output.

As an improvement, module 100 may include the addition of buffers B1-B6 as illustrated in FIG. 2C, 3C and 4C. Specifically, buffer B1 may be disposed in a routing path for Q-clock. Buffers B2-B5 may be disposed in respective data paths in module 100. Buffer B6 may be disposed in a routing path for I-clock. The disposition of buffers B1-B6 the routing paths and data paths may result in a matching of propagation delays for Q-clock, I-clock and the data signals while also enhancing the ability of module 100 to supply power to a load without degrading the performance of module 100. This can be used to support another specific application which should have large output driver size to drive an output laser modulator directly without any external output laser driver. By adding buffer for both data and clock paths, we can scale up the second stage MUX, M23 and M26 size while keeping the input clock loading the same and also achieving the delay matching between t1 and t2.

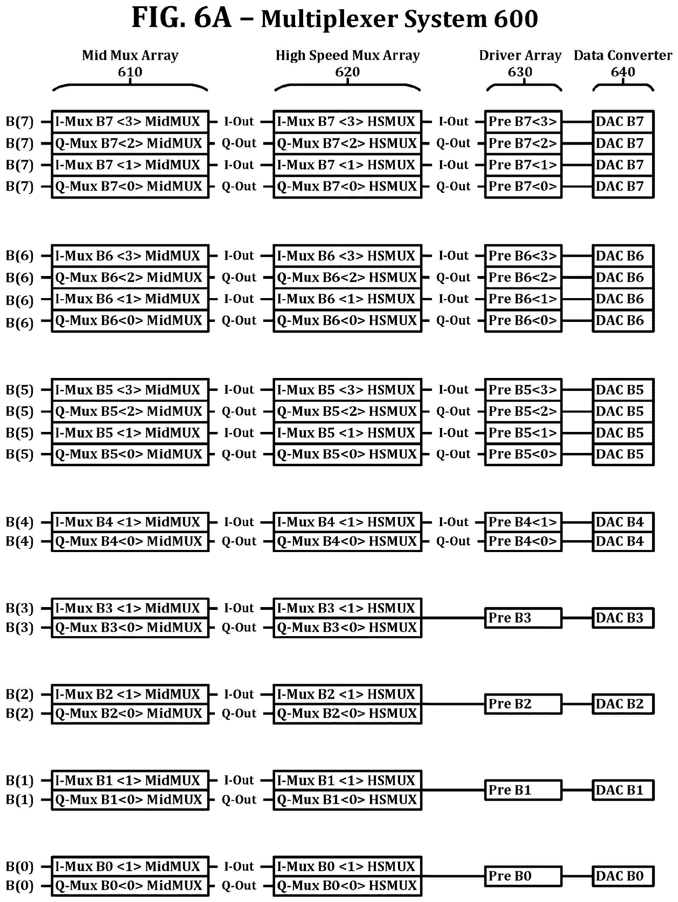

Referring now to FIG. 6, multiplexer system 600 is illustrated. Multiplexer system may include mid mux array 610, high speed mux array 620, driver array 630 and data converter 640. In the example of FIG. 6, multiplexer system 600 may convert bits B(0)-B(7) of digital information into an analog sig. Bit B(7) is the most significant bit and bit B(0) is the least significant bit. Those skilled in the art will appreciate that, although an 8-bit length having bits B(0)-B(7) is illustrated, multiplexer system 600 may convert digital information of bit lengths greater than an 8-bit length or less than an 8-bit length.

Mid mux array 610 may include a plurality of multiplexer slices. The multiplexer slices may each be driven by even phase clocking <0,2,4,8> generate outputs I-out or by odd phase clocking <1,3,5,7> generate outputs Q-out, respectively. Each of the multiplexer slices may be individually designated as either I-Mux BX or Q-Mux BX, with "X" being a number matching a corresponding bit. An "I-Mux" slice in mid mux array 610 may be I-mux slice 104 whereas a "Q-Mux" slice in mid mux array 610 may be Q-mux slice 103. Mid mux array 610 may receive bits B(0)-B(7). Illustrated by example, an I-Mux BX receiving bit B(7) in mid mux array 610 is designated as I-Mux B7. A Q-Mux BX receiving bit B(7) in mid mux array 610 is designated as Q-Mux B7.

High speed mux array 620 may include a plurality of multiplexer slices. The multiplexer slices may each be driven by even phase clocking <0,2,4,8> generate outputs I-out or by odd phase clocking <1,3,5,7> generate outputs Q-out, respectively. High speed MUX is driven by 4T (= DAC output symbol rate/4) <0,1,2,3>. Both even and odd clocks are used. Mid-MUX clock is 8T rate with 8-phase <0,1,2,3,4,5,6,7>.

Each of the multiplexer slices may be individually designated as either I-Mux BX or Q-Mux BX, with "X" being a number matching a corresponding bit. An "I-Mux" slice in high speed mux array 620 may be I-mux slice 104 whereas a "Q-Mux" slice in high speed mux array 620 may be Q-mux slice 103. High speed mux array 620 may receive bits B(0)-B(7). Each bit, B(0) input for HSMUX consists of four parallel input like the bottom of Fig.6. HSMUX converts B(0)<0,1,2,3> at 4T rate to a single full-rate data B(0) at 1T.

Illustrated by example, I-Mux BX and Q-Mux BX receiving bit B(7) in high speed mux array 620 are designated as I-Mux B7 and Q-Mux B7, respectively.

Driver array 630 may include a plurality of drivers. Each of the drivers may be individually designated as Pre BX, with "X" being a number matching a corresponding bit. Illustrating by example, Pre BX receiving bit B(7) in driver array 630 are designated as Pre B7. Referring to the example of FIG. 5B, Pre BX in driver array 630 may be O-line driver 52. Pre BX in driver array 630 may be O-line driver 52 combined with I-line driver 53.

The odd-numbered time periods may occur in synchronization with I-clock. For example, time period 1T may commence on a rising edge of I-clock and conclude on the successive falling edge of Q-clock. Time period 3T may commence on a falling edge of I-clock and conclude on the successive rising edge of I-clock. The even-numbered time periods may occur in synchronization with Q-clock. For example, time period 0T may commence on a rising edge of Q-clock. Time period 2T may commence on a rising edge of Q-clock and conclude on the successive falling edge of Q-clock. Time period 4T may commence on a falling edge of Q-clock.

The portion of first stage 201 in Q-mux slice 103 may receive Q-clock. The portion of second stage 202 in Q-mux slice 103 may receive I-clock. Accordingly, Q-mux slice 103 may propagate odd phase outputs on data lines S1, S2 onto output line (Q-out).

The portion of first stage 201 in I-mux slice 104 may receive I-clock. The portion of second stage 202 in I-mux slice 104 may receive Q-clock. Accordingly, I-mux slice 104 may propagate even phase outputs on data lines S3, S4 onto output line (I-out).

Those skilled in the art will also appreciate the arrangement or interconnection of components such as "coupled," "connected," "on," "under," or similar wording allows for indirect connections, or intervening components or layers.

Certain operations of methods according to the technology, or of systems executing those methods, may be represented schematically in the figures or otherwise discussed herein. Unless otherwise specified or limited, representation in the figures of particular operations in particular spatial order may not necessarily require those operations to be executed in a particular sequence corresponding to the particular spatial order. Correspondingly, certain operations represented in the figures, or otherwise disclosed herein, may be executed in different orders than are expressly illustrated or described, as appropriate for particular examples of the technology. Further, in some examples, certain operations may be executed in parallel or partially in parallel, including by dedicated parallel processing devices, or separate computing devices configured to interoperate as part of a large system.

As used herein, unless otherwise limited or defined, "or" indicates a non-exclusive list of components or operations that may be present in any variety of combinations, rather than an exclusive list of components that may be present only as alternatives to each other. For example, a list of "A, B, or C" indicates options of: A; B; C; A and B; A and C; B and C; and A, B, and C.

Correspondingly, the term "or" as used herein is intended to indicate exclusive alternatives only when preceded by terms of exclusivity, such as, e.g., "either," "only one of," or "exactly one of." Further, a list preceded by "one or more" (and variations thereon) and including "or" to separate listed elements indicates options of one or more of any or all of the listed elements.

For example, the phrases "one or more of A, B, or C" and "at least one of A, B, or C" indicate options of: one or more A; one or more B; one or more C; one or more A and one or more B; one or more B and one or more C; one or more A and one or more C; and one or more of each of A, B, and C.

Similarly, a list preceded by "a plurality of" (and variations thereon) and including "or" to separate listed elements indicates options of multiple instances of any or all of the listed elements. For example, the phrases "a plurality of A, B, or C" and "two or more of A, B, or C" indicate options of: A and B; B and C; A and C; and A, B, and C.

In general, the term "or" as used herein only indicates exclusive alternatives (e.g., "one or the other but not both") when preceded by terms of exclusivity, such as, e.g., "either," "only one of," or "exactly one of."

Any mark, if referenced herein, may be common law or registered trademarks of third parties affiliated or unaffiliated with the applicant or the assignee. Use of these marks is by way of example and shall not be construed as descriptive or to limit the scope of disclosed or claimed embodiments to material associated only with such marks.

The articles "a," "an," and "the" are intended to include the plural forms as well, unless the context clearly indicates otherwise.

The terms "comprises," "includes," and "has" specify the presence of stated features, numbers, operations, members, elements, and/or combinations thereof, but do not preclude the presence or addition of one or more other features, numbers, operations, members, elements, and/or combinations thereof.

**Claims**

1. A module comprising:

   a first slice configured to receive data from a plurality of inputs; and
   a second slice configured to receive the data from the inputs,

   wherein:

   a first stage of the first slice is configured to select, in synchronization with an edge of a first clock, a first subset of the inputs,
   a second stage of the first slice is configured to select, in synchronization with a second clock, one of the inputs from the first subset,
a first stage of the second slice is configured to select, in synchronization with an edge of the second clock, a second subset of the inputs, and
a second stage of the second slice is configured to select, in synchronization with the first clock, one of the inputs from the second subset.

2. The module according to claim 1, wherein
the second stage of the first slice is configured to select the one of the inputs in the first subset in synchronization with an opposite edge of the second clock.

3. The module according to claim 1 or 2, wherein
the second stage of the second slice is configured to select the one of the inputs in the second subset in synchronization with an opposite edge of the first clock.

4. The module according to any one of the claims 1 to 3, wherein
an inverter in the first slice is configured output the first clock to the second stage of the second slice.

5. The module according to claim 4, further comprising:
a plurality of buffers in the first slice, one of the buffers in the first slice is configured to transfer the first clock from the inverter to the second stage of the second slice.

6. The module according to claim 5, wherein
others of the buffers in the first slice are configured to transfer the first subset from the first stage of the first slice to the second stage of the first slice.

7. The module according to any one of the claims 1 to 6, wherein
an inverter in the second slice is configured output the second clock to the second stage of the first slice.

8. The module according to claim 7, further comprising:
a plurality of buffers in the second slice, one of the buffers in the second slice is configured to transfer the second clock from the inverter to the second stage of the first slice; wherein in particular
others of the buffers in the second slice are configured to transfer the second subset from the first stage of the second slice to the second stage of the second slice.

9. The module according to any one of the claims 1 to 8, wherein
the edge of the second clock is between the edge of the first clock and a successive edge of the first clock.

10. The module according to any one of the claims 1 to 9, wherein

the second clock is out of phase with the first clock; wherein in particular
the second clock is a clock shifted by 90 degrees from the first clock.

11. The module according to any one of the claims 1 to 10, wherein
the first stage of the first slice comprises a multiplexer, the multiplexer in the first slice is configured to select, from a grouping of the inputs, the one of the inputs in the first subset.

12. The module according to claim 11, wherein
the first stage of the first slice comprises an additional multiplexer, the additional multiplexer in the first slice is configured to select, from another grouping of the inputs, an additional one of the inputs in the first subset.

13. The module according to any one of the claims 1 to 12, wherein

the first stage of the second slice comprises a multiplexer, the multiplexer in the second slice is configured to select, from a grouping of the inputs, the one of the inputs in the second subset; wherein in particular
the first stage of the first slice comprises an additional multiplexer, the additional multiplexer in the second slice is configured to select, from another grouping of the inputs, an additional one of the inputs in the second subset.

14. The module according to any one of the claims 1 to 13, further comprising:

a conductive interconnection configured to electrically connect an output of the first stage directly to an output of the second stage.

**15.** A serializer comprising,

the module according to any one of the claims 1 to 14; and
a driver.

# FIG. 1 – Module 100

EP 4 712 351 A1

# FIG. 2A – Module 100(A)

EP 4 712 351 A1

# FIG. 2B – Module 100(B)

EP 4 712 351 A1

# FIG. 2C – Module 100(C)

EP 4 712 351 A1

# FIG. 3A – Q-Mux Slice 103(A)

# FIG. 3B – Q-Mux Slice 103(B)

# FIG. 3C – Q-Mux Slice 103(C)

# FIG. 4A – I-Mux Slice 104(A)

# FIG. 4B – I-Mux Slice 104(B)

# FIG. 4C – I-Mux Slice 104(C)

# FIG. 5A – Interpolation

Q-clk/Q-inv

I-clk/I-inv

D3

D2

Q-Mux
Slice
103

D0

D1

Q-Out

Interconnection
51

INT-Out

D3

D0

I-Mux
Slice
104

D2

D1

I-Out

Q-clk/Q-inv

I-clk/I-inv

EP 4 712 351 A1

# FIG. 5B – Interpolation Example

EP 4 712 351 A1

# FIG. 5C – Interpolation Timing

EP 4 712 351 A1

# FIG. 6A – Multiplexer System 600

| Mid Mux Array 610 | High Speed Mux Array 620 | Driver Array 630 | Data Converter 640 |
|---|---|---|---|

B(7) — I-Mux B7 <3> MidMUX — I-Out — I-Mux B7 <3> HSMUX — I-Out — Pre B7<3> — DAC B7
B(7) — Q-Mux B7<2> MidMUX — Q-Out — Q-Mux B7<2> HSMUX — Q-Out — Pre B7<2> — DAC B7
B(7) — I-Mux B7 <1> MidMUX — I-Out — I-Mux B7 <1> HSMUX — I-Out — Pre B7<1> — DAC B7
B(7) — Q-Mux B7<0> MidMUX — Q-Out — Q-Mux B7<0> HSMUX — Q-Out — Pre B7<0> — DAC B7

B(6) — I-Mux B6 <3> MidMUX — I-Out — I-Mux B6 <3> HSMUX — I-Out — Pre B6<3> — DAC B6
B(6) — Q-Mux B6<2> MidMUX — Q-Out — Q-Mux B6<2> HSMUX — Q-Out — Pre B6<2> — DAC B6
B(6) — I-Mux B6 <1> MidMUX — I-Out — I-Mux B6 <1> HSMUX — I-Out — Pre B6<1> — DAC B6
B(6) — Q-Mux B6<0> MidMUX — Q-Out — Q-Mux B6<0> HSMUX — Q-Out — Pre B6<0> — DAC B6

B(5) — I-Mux B5 <3> MidMUX — I-Out — I-Mux B5 <3> HSMUX — I-Out — Pre B5<3> — DAC B5
B(5) — Q-Mux B5<2> MidMUX — Q-Out — Q-Mux B5<2> HSMUX — Q-Out — Pre B5<2> — DAC B5
B(5) — I-Mux B5 <1> MidMUX — I-Out — I-Mux B5 <1> HSMUX — I-Out — Pre B5<1> — DAC B5
B(5) — Q-Mux B5<0> MidMUX — Q-Out — Q-Mux B5<0> HSMUX — Q-Out — Pre B5<0> — DAC B5

B(4) — I-Mux B4 <1> MidMUX — I-Out — I-Mux B4 <1> HSMUX — I-Out — Pre B4<1> — DAC B4
B(4) — Q-Mux B4<0> MidMUX — Q-Out — Q-Mux B4<0> HSMUX — Q-Out — Pre B4<0> — DAC B4

B(3) — I-Mux B3 <1> MidMUX — I-Out — I-Mux B3 <1> HSMUX — Pre B3 — DAC B3
B(3) — Q-Mux B3<0> MidMUX — Q-Out — Q-Mux B3<0> HSMUX

B(2) — I-Mux B2 <1> MidMUX — I-Out — I-Mux B2 <1> HSMUX — Pre B2 — DAC B2
B(2) — Q-Mux B2<0> MidMUX — Q-Out — Q-Mux B2<0> HSMUX

B(1) — I-Mux B1 <1> MidMUX — I-Out — I-Mux B1 <1> HSMUX — Pre B1 — DAC B1
B(1) — Q-Mux B1<0> MidMUX — Q-Out — Q-Mux B1<0> HSMUX

B(0) — I-Mux B0 <1> MidMUX — I-Out — I-Mux B0 <1> HSMUX — Pre B0 — DAC B0
B(0) — Q-Mux B0<0> MidMUX — Q-Out — Q-Mux B0<0> HSMUX

# EUROPEAN SEARCH REPORT

**Application Number**

EP 25 20 1395

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/195274 A1 (KIM SUHWAN [KR] ET AL) 18 June 2020 (2020-06-18) * paragraph [0005]; figures 1-3 * ----- | 1-15 | INV. H03M9/00 |

**TECHNICAL FIELDS SEARCHED (IPC)**

H03M

The present search report has been drawn up for all claims

| Place of search | Date of completion of the search | Examiner |
|---|---|---|
| The Hague | 30 January 2026 | Jesus, Paulo |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 20 1395

This annex lists the patent family members relating to the patent documents cited in  the above-mentioned European search report.
The members are as contained in the European Patent Office EDP file on
The European Patent Office is in no way liable for these particulars which are merely given for the purpose of information.

30-01-2026

| Patent document cited in search report | Publication date | Patent family member(s) | Publication date |
|---|---|---|---|
| US 2020195274 A1 | 18-06-2020 | KR 20200074646 A<br>US 2020195274 A1 | 25-06-2020<br>18-06-2020 |

EPO FORM P0459

For more details about this annex : see Official Journal of the European Patent Office, No. 12/82